# EUROPÄISCHE PATENTSCHRIFT

(11) **EP 1 865 760 B1**
(45) Veröffentlichungstag und Bekanntmachung des Hinweises auf die Patenterteilung: **06.10.2010**
(21) Anmeldenummer: 07107629.3
(22) Anmeldetag: 07.05.2007
(51) Int. Cl.: H05K 3/34

(54) **Lötverfahren**
Soldering method
Procédé de soudage

(30) Priorität: 08.06.2006 DE 102006027027
(43) Veröffentlichungstag der Anmeldung: 12.12.2007
(73) Patentinhaber: centrotherm thermal solutions GmbH & Co. KG, 89143 Blaubeuren (DE)
(72) Erfinder: Hartung, Robert Michael, 89143, Blaubeuren (DE); Völler, Hans Ulrich, 89143 Blaubeuren (DE)
(74) Vertreter: Lippert, Stachow & Partner

(56) Entgegenhaltungen:
- WO-A-2005/077583
- DE-A1- 19 506 763
- US-A- 6 100 496
- "SOLDEREN ZONDER VLOEIMIDDEL" POLYTECHNISCH TIJDSCHRIFT, ELEKTROTECHNIEK, ELEKTRONICA, STAM TIJDSCHRIFTEN, RIJSWIJK, NL, Bd. 49, Nr. 8, 1. August 1994 (1994-08-01), Seite 53, XP000466657 ISSN: 0925-5672

## Beschreibung

Die Erfindung betrifft ein Lötverfahren zum lunkerfreien Reflowlöten von Fügepartnern unter Vakuum in einem Rezipienten, wie elektrische Bauteile o.dgl. auf Leiterplatten oder anderen Trägerelementen, durch Beladen des Rezipienten mit den miteinander zu verbindenden Fügepartnern und Absenken des Druckes im Rezipienten sowie gleichzeitiges Aufheizen der Fügepartner.

Um ein lunkerfreies (voidless) Reflowlöten zu gewährleisten, muss der Lötprozess im Vakuum z.B. in einem Rezipienten (evakuierbare Kammer), durchgeführt werden. Zu diesem Zweck wird während des Lötprozesses, d.h. in der liquiden Phase des Lotes, der Druck vom Normaldruck auf mindestens 10⁻³ mbar abgesenkt. Auf diese Weise wird erreicht, dass sich Lunker, die sich im Lot befinden und weiterhin Normaldruck aufweisen, nach außen durch das Lot entweichen können.

Weiterhin ist es erforderlich, sowohl die Oberfläche des Lotes, als auch die zu lötende Oberfläche der Fügepartner vor dem Löten vollständig von Oxid zu befreien, da andernfalls keine metallische Verbindung der Fügepartner möglich ist. Für die Aktivierung der Fügepartner werden in der Regel chemische Flussmittel eingesetzt, die aus harzhaltigen Materialien, ergänzt mit sauren Bestandteilen, bestehen.

Allerdings entstehen beim Löten mit solchen Flussmitteln giftige Dämpfe und es verbleiben meist Flussmittelrückstände auf den Fügepartnern, die häufig einen zusätzlichen Reinigungsprozess notwendig machen. Der Auftrag des Flussmittels auf eine bestückte Leiterplatte kann beispielsweise durch Aufsprühen und nachfolgendes Vorwärmen derselben zum Aktivieren des Flussmittels erfolgen.

Eine andere Möglichkeit zur Aktivierung des Lotes und der Oberflächen der Fügepartner in Bezug auf die störenden Oxidschichten besteht in der Verwendung von nass aktivierender Ameisensäure (HCOOH), oder von reduzierendem Wasserstoff. Der Wasserstoffanteil verbindet sich dabei mit dem Sauerstoff der Oxidschichten zu Wasser. Im Falle eines Vakuumlötprozesses wird das gasförmige Wasser dann über die ohnehin erforderliche Vakuumpumpe abgesaugt.

Ein ähnliches Flussmittel wird in der DE 695 22 993 T2, mit Pimelinsäure als primären aktiven Bestandteil, beschrieben. Pimelinsäure ist ein Feststoff mit einer besonders niedrigen Schmelztemperatur.

Eine andere Variante ist die Reduzierung der Oxidschichten mit Wasserstoffionen. Hier werden zur Aktivierung des Wasserstoffs (Aufspaltung von H₂ zu H-Ionen) jedoch Temperaturen von über 350°C benötigt. Nachteilig hierbei ist allerdings die Verwendung von Wasserstoff, was aus Sicherheitsgründen (Knallgasbildung) als sehr kritisch angesehen werden muss. Darüber hinaus sind die meisten Halbleiter nach einer Temperaturbeaufschlagung von über 350 °C dann nicht mehr funktionsfähig. Damit scheidet der Einsatz von Wasserstoff zur Reduzierung der Oxidschichten in vielen Anwendungsfällen aus.

Bei einer nasschemischen Aktivierung mit Ameisensäure bleibt nach einem Lötzyklus immer ein Formiatrest (Salze) auf der Oberfläche. Gegebenenfalls muss zusätzlich eine Oberflächenreinigung vorgenommen werden. Damit scheidet auch diese Art der Oberflächenaktivierung in vielen Anwendungsfällen aus.

In der DE 696 03 418 T2 wird ein Verfahren und eine Vorrichtung zum Weichlöten mit integriertem Trockenflussverfahren beschrieben. Ausgangspunkt hierbei ist ein Ausgangsgasgemisch, das ein Inertgas und/oder ein reduzierendes Gas und/oder ein oxydierendes Gas enthält. Aus diesem Gasgemisch wird nach der Umwandlung an einer Gasaustrittsöffnung ein Gasgemisch erzeugt, welches erregte oder instabile Gasarten enthält und im Wesentlichen frei von elektrisch geladenen Arten ist.

Die Erzeugung der erregten oder instabilen Gasarten erfolgt in mindestens zwei Geräten, die jeweils mit Gasaustrittsöffnungen versehen sind und von denen in mindestens einem Gerät eine elektrische Entladung stattfindet. Die Behandlung der Fügepartner mit den genannten Gasarten erfolgt bei einem atmosphärischen Druck von ungefähr 0,1 und 3 bar.

Als Inertgase kommen beispielsweise Stickstoff, Argon, Helium oder Gemische davon in Betracht. Reduzierende Gase können sein Wasserstoff, CH₄, Ammoniak, SiH₄ oder Gemische davon, sowie oxydierende Gase CO₂, N₂O, H₂O oder Gemische derselben.

Der Wasserdampfgehalt im Ausgangsgasgemisch sollte im Bereich zwischen 500 ppm und 1000 ppm liegen.

Dieses Verfahren ist auch wegen der erforderlichen technischen Ausrüstung sehr aufwändig. Immerhin sind drei Zonen zur Realisierung des Verfahrens erforderlich. Das sind eine Zone zur Vorwärmung der Schaltkreise, eine weitere Zone zur beidseitigen Behandlung der Schaltkreise mit den primären Gasgemischen vor dem Löten und eine dritte Zone zum eigentlichen Schwalllöten.

In der DE 695 24 421 T2 wird ein Kolophonium freies No-Clean-Lötflussmittel mit niedrigem VOC-Gehalt (volatile organic compound-Gehalt), also mit einem niedrigen Anteil an flüchtigen organischen Verbindungen, beschrieben, das auf der Verwendung eines halogenidfreien Carbonsäure-Activators in Kombination mit Acrylamin und Wasser basiert.

Allen diesen Verfahren ist gemeinsam, dass diese einen erheblichen Aufwand bei der Herstellung des Flussmittels, bei der Vorbereitung des Lötprozesses und auch bei der Nachbehandlung der Fügepartner nach dem Lötprozess erfordern.

Der Erfindung liegt daher die Aufgabe zugrunde, ein Lötverfahren zum lunkerfreien Reflowlöten von Fügepartnern zu schaffen, das besonders einfach zu realisieren ist und bei dem keinerlei Nachbehandlung der Fügepartner nach dem Lötprozess erforderlich ist und das keinerlei Umweltrisiko mit sich bringt.

Die der Erfindung zugrunde liegende Aufgabe wird bei einem Lötverfahren zum lunkerfreien Reflowlöten von Fügepartnern unter Vakuum in einem Rezipienten, wie elektrische Bauteile o.dgl. auf Leiterplatten oder anderen Trägerelementen, durch Beladen des Rezipienten mit den miteinander zu verbindenden Fügepartner und Absenken des Druckes im Rezipienten sowie gleichzeitiges Aufheizen der Fügepartner, gelöst durch Zünden eines Plasmas bei Erreichen des zum Zünden erforderlichen Druckes, oder Einleiten eines Remote-Plasmas in den Rezipienten, Einsprühen von Wasser in den Rezipienten und Aufspaltung in H-Ionen und 0-Ionen durch das Plasma, Aktivierung der Oberfläche der Fügepartner und des Lotes durch Aufoxidation und Abtrag der Kohlenstoffschicht sowie nachfolgendes Verbinden des Sauerstoffs der Oxidschicht mit Wasserstoff, Beenden des Reflowlötprozesses und Belüften des Rezipienten nach Ablauf einer vorgegebenen Haltezeit.

Bevorzugt ist das im Rezipienten gezündete Plasma ein Niederdruckplasma im RF Bereich (kHz...MHz). Alternativ kann das Plasma bei einer Hochfrequenz-Anlage im GHz Bereich auch als Remote-Plasma in einer mit dem Rezipienten verbundenen Vorkammer gezündet werden, wonach dann das Plasma in den Rezipienten geleitet wird.

Weiterhin wird der Druck im Rezipienten auf den Niederdruckbereich von mindestens 10⁻³ mbar abgesenkt.

In einer Fortführung der Erfindung werden die Fügepartner stufenweise erwärmt. Vorzugsweise werden die Fügepartner zunächst auf eine Temperatur unterhalb der Löttemperatur zum Aktivieren der Oberflächen der Fügepartner durch die 0-Ionen und die H-Ionen und nach einer vorgegebenen Zeit auf die Löttemperatur erwärmt. Damit lässt sich die Zeitdauer der Aktivierung der Oberflächen der Fügepartner sowie des Reflowlötprozesses steuern.

Um eine besonders gute Entfernung der Lunker im Lot zu erreichen, kann der Druck im Rezipienten mit Erreichen der Löttemperatur kurzzeitig weiter abgesenkt werden.

In einer weiteren Ausgestaltung der Erfindung wird das Wasser vor dem Einsprühen in den Rezipienten vorgewärmt.

Für die Erwärmung der Fügepartner kann Infrarot- oder Halogenstrahlung, oder auch eine Widerstandsheizung genutzt werden.

Alternativ können die Fügepartner auch mittels Kontaktheizung oder Konvektionsheizung erwärmt werden.

Eine besonders schnelle und punktgenaue Erwärmung der Fügepartner kann mittels Laserstrahl erreicht werden.

Damit wird eine auch für den einschlägigen Fachmann überraschend einfache Lösung der der Erfindung zugrunde liegenden Aufgabe erreicht, da im Stand der Technik ausnahmslos von Gemischen von Flussmitteln unterschiedlicher Art ausgegangen worden ist und hier aufgezeigt wird, dass reines Wasser als Flussmittel bei Vakuumlötprozessen vollkommen ausreichend ist.

Das erfindungsgemäße Verfahren ist auch besonders kostengünstig, absolut ungefährlich und außerordentlich umweltfreundlich.

Außerdem lässt sich das erfindungsgemäße Verfahren sehr leicht und mit geringem Aufwand in bereits bestehende Vakuumlötprozesse integrieren.

Weiterhin kann das Lötverfahren bei sämtlichen metallischen Fügepartnern unter Einsatz beliebiger metallischer Lote eingesetzt werden. Damit ist das erfindungsgemäße Verfahren absolut universell einsetzbar.

Die Erfindung soll nachfolgend an einem Ausführungsbeispiel näher erläutert werden. In den zugehörigen Zeichnungsfiguren zeigen:
- Fig. 1:: eine schematische Darstellung einer Nieder-, Mittel- frequenz-Anlage zum Reflowlöten; und
- Fig. 2:: eine schematische Darstellung einer Hochfrequenz- Anlage zum Reflowlöten.

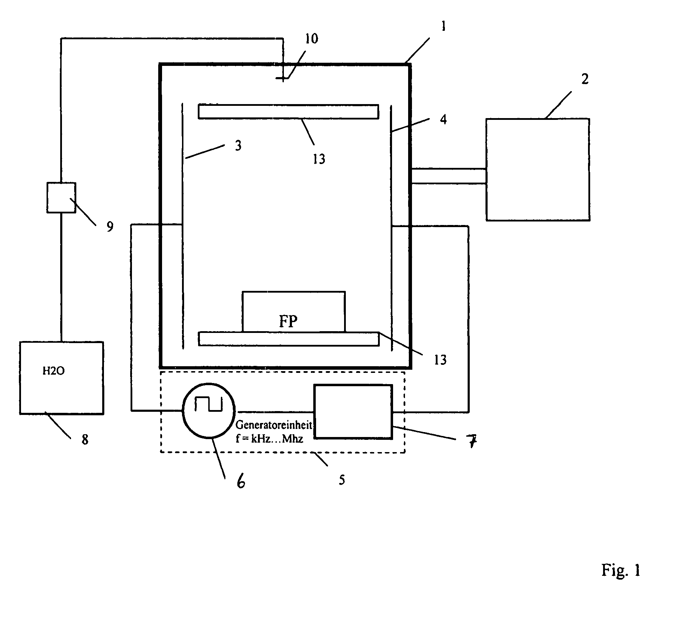

Ausgangspunkt ist eine übliche Reflowlöteinrichtung, die in einer evakuierbaren Kammer, z.B. einem Rezipienten 1, angeordnet ist, so dass ein Vakuumlötprozess ausgeführt werden kann. Die zu lötenden Fügepartner FP sind nur schematisch angedeutet, da deren Gestalt an sich beliebig sein kann. Fügepartner FP können beispielsweise mit Halbleiterchips oder mit FBGA-Halbleiterbauelementen bestückte Leiterplatten oder andere Bauteile sein.Zur Ausführung des Vakuum-Reflowlötprozesses ist der Rezipient 1 mit einer Vakuumpumpe 2 verbunden, mit welcher der Innendruck im Rezipienten 1 während des Lötprozesses in der liquiden Phase des Lotes auf einen Druck um 10⁻³ mbar oder weniger abgesenkt werden kann. Dadurch können im Lot befindliche Lunker nach außen in die Atmosphäre in der Kammer 1 entweichen (Fig. 1).Weiterhin befindet sich im Rezipienten 1 eine Einrichtung zum Zünden eines Niederdruckplasmas im kHz...MHz-Bereich während des Vakuumprozesses. Dazu sind im Rezipienten 1 zwei Elektroden 3, 4 angeordnet, die mit einer Generatoreinheit 5, bestehend aus einem Frequenzgenerator 6 und einem zugehörigen Regler 7, verbunden sind. In das während des Vakuumprozesses gezündete Plasma wird Wasser eingesprüht, was infolge des Unterdruckes in der Kammer ohne jegliche weitere Pumpe erfolgt. Dazu wird das Wasser aus einem Vorratsbehälter 8 über einen LMC 9 (Liquid Massflow Controller - Flüssigkeitsmengen-Regler) und eine schematisch angedeutete Düse oder Lanze 10 in den Rezipienten 1 eingebracht. Infolge des Unterdruckes in der Kammer wird das Wasser durch die Düse oder Lanze 10 gesaugt und dadurch beim Eintritt in den Rezipienten 1 fein zerstäubt.

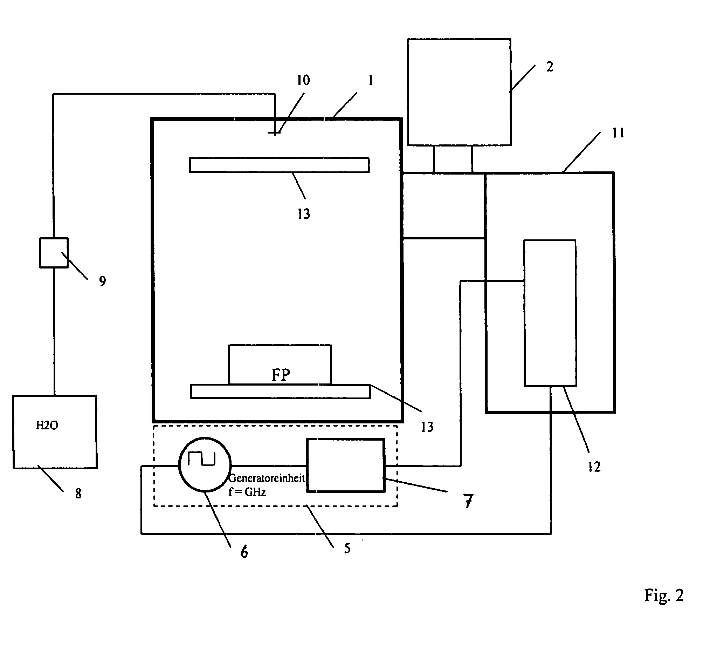

Fig. 2 zeigt eine schematische Darstellung einer Hochfrequenz-Anlage zum Reflowlöten mit einer Plasmaquelle 12 in einer Vorkammer 11, die mit dem Rezipienten 1 verbunden ist. Das benötigte Plasma wird hier durch die Plasmaquelle 12, die mit der Generatoreinheit 5 elektrisch verbunden ist, in der Vorkammer 11 erzeugt und als Remote-Plasma in den Rezipienten 1 eingespeist.

Das im Rezipienten 1 zerstäubte Wasser wird durch das Plasma sofort in seine Bestandteile, d.h. H-Ionen und O-Ionen zerlegt.

Der nun stattfindende Prozess der Oberfächenaktivierung der Fügepartner FP und des Lotes erfolgt zweistufig. Zunächst reagieren die O-Ionen mit der Oberfläche durch Aufoxidation und Abtrag der Kohlenstoffschicht gemäß der Formel C + 20 -> CO₂.

Im nächsten Schritt wirkt der im Wasser in höherer Konzentration vorhandene Wasserstoff reduzierend auf die oxidierte Oberfläche der Fügepartner FP und des Lotes, indem sich der Wasserstoffanteil mit dem Sauerstoff der Oxidschicht zu Wasser verbindet. Die Entfernung des Wassers aus dem Rezipienten 1 erfolgt dann nach Abschalten des Plasmas über die vorhandene Vakuumpumpe 2.

Das Ergebnis ist eine optimal lötfähige, da absolut saubere und oxidfreie Oberfläche.

Der eigentliche Reflowlötprozess muss dann sofort anschließend an die Oberflächenaktivierung oder gleichzeitig erfolgen, um eine erneute Oxidbildung vor dem Lötvorgang auszuschließen. Im nächsten Schritt wird dann der Rezipient 1 belüftet, so dass nach einem kurzen Abkühlprozess das gelötete Bauteil entnommen werden kann.

Die Verfahrensschritte lassen sich wie folgt zusammenfassen:
- Beladen des Rezipienten 1 mit den miteinander zu verbindenden Fügepartnern FP (z.B. mit Bauelementen bestückte Leiterplatten),
- Absenken des Innendruckes des Rezipienten 1 und gleichzeitiges Aufheizen der Fügepartner FP auf Löttemperatur,
- Zünden eines Plasmas im Rezipienten 1 bei Erreichen des zum Zünden erforderlichen Druckes bei 3 - 10 mbar, oder Einleiten eines Remote-Plasmas in den Rezipienten 1,
- Einsprühen von Wasser in den Rezipienten 1 und Aufspaltung in H-Ionen und O-Ionen,
- Aktivierung der Oberfläche der Fügepartner FP und des Lotes durch Aufoxidation und Abtrag der Kohlenstoffschicht und nachfolgendes Verbinden des Sauerstoffs der Oxidschicht mit Wasserstoff,
- Beenden des Reflowlötprozesses und Belüften des Rezipienten 1.

Das Aufheizen der Fügepartner FP kann mittels einer geeigneten Heizeinrichtung 13 durch Strahlungsheizung mit Halogen- oder Infrarotstrahlern oder anderen geeigneten Mitteln von außerhalb oder innerhalb des Rezipienten 1 erfolgen.

Andere Möglichkeiten der Erwärmung der Fügepartner sind innerhalb des Rezipienten 1 Widerstandsheizung, Kontaktheizung, Konvektionsheizung, oder auch Erwärmung mittels Laserstrahl.

Die Heizeinrichtung 13 ist deshalb in den Fig. 1 und 2 nur schematisch dargestellt.

Die besonderen Vorteile des erfindungsgemäßen Verfahrens sind die ausschließliche Verwendung von Wasser als Flussmittel, das nahezu überall und kostengünstig verfügbar ist und die Tatsache, dass Wasser ohne jedes Sicherheitsrisiko unbegrenzt lagerfähig ist. Wasser ist weiterhin ohne Sicherheitsrisiko bei thermischen Prozessen einsetzbar, wobei keine höheren Temperaturen für die Oberflächenaktivierung erforderlich sind, als für den Reflowlötprozess ohnehin notwendig sind.

Das Verfahren ist nicht auf die Verwendung eines bestimmten Lotes oder eine bestimmte Metallkombinationen beschränkt, sondern ist bei sämtlichen Metallkombinationen einsetzbar, die Lötfähig sind.

Schließlich ist das erfindungsgemäße Verfahren absolut umweltfreundlich, da keinerlei Säuren eingesetzt werden.

Darüber hinaus lässt sich das erfindungsgemäße Verfahren problemlos in bestehende Vakuumlötprozesse integrieren.

### Bezugszeichenliste

- 1: Rezipient
- 2: Vakuumpumpe
- 3: Elektrode
- 4: Elektrode
- 5: Generatoreinheit
- 6: Frequenzgenerator
- 7: Regler
- 8: Vorratsbehälter
- 9: LMC
- 10: Düse / Lanze
- 11: Vorkammer
- 12: Plasmaquelle
- 13: Heizeinrichtung

- FP: Fügepartner

## Patentansprüche

1. Lötverfahren zum lunkerfreien Reflowlöten von Fügepartnern (FP) unter Vakuum in einem Rezipienten (1), wie elektrische Bauteile oder dergleichen auf Leiterplatten oder anderen Trägerelementen, durch Beladen des Rezipienten (1) mit den miteinander zu verbindenden Fügepartnern (FP) und Absenken des Druckes im Rezipienten (1) sowie gleichzeitigem Aufheizen der Fügepartner (FP) und Zünden eines Plasmas, **dadurch gekennzeichnet, dass das** Zünden des Plasmas im Rezipienten (1) bei Erreichen des zum Zünden erforderlichen Druckes im Rezipienten (1) erfolgt oder das Plasma als Remote Plasma in einer Vorkammer (11) gezündet und in den Rezipienten (1) eingeleitet wird, Einsprühen von Wasser in den Rezipienten (1) und Aufspaltung in H-Ionen und O-Ionen durch das Plasma, Aktivierung der Oberfläche der Fügepartner (FP) und des Lotes durch Aufoxidation und Abtrag der Kohlenstoffschicht sowie nachfolgendes Verbinden des Sauerstoffs der Oxidschicht mit Wasserstoff, Beenden des Reflowlötprozesses und Belüften des Rezipienten (1) nach Ablauf einer vorgegebenen Haltezeit.

2. Verfahren nach Anspruch 1, **dadurch gekennzeichnet, dass das** im Rezipienten (1) gezündete Plasma ein Niederdruckplasma im RF Bereich (kHz...MHz) ist.

3. Verfahren nach Anspruch 1, **dadurch gekennzeichnet, dass** das Plasma ein Niederdruckplasma im GHz Bereich ist.

4. Verfahren nach Anspruch 1, **dadurch gekennzeichnet, dass** der Druck im Rezipienten (1) auf 10⁻³ mbar abgesenkt wird.

5. Verfahren nach Anspruch 1, **dadurch gekennzeichnet, dass** die Fügepartner (FP) stufenweise erwärmt werden.

6. Verfahren nach Anspruch 5, **dadurch gekennzeichnet, dass** die Fügepartner (FP) zunächst auf eine Temperatur unterhalb der Löttemperatur zum Aktivieren der Oberflächen der Fügepartner und nach einer vorgegebenen Zeit auf die Löttemperatur erwärmt werden.

7. Verfahren nach Anspruch 6, **dadurch gekennzeichnet, dass** mit Erreichen der Löttemperatur der Druck im Rezipienten (1) kurzzeitig weiter abgesenkt wird.

8. Verfahren nach Anspruch 1, **dadurch gekennzeichnet, dass** das Wasser vor dem Einsprühen in den Rezipienten (1) vorgewärmt wird.

9. Verfahren nach einem der Ansprüche 1 bis 8, **dadurch gekennzeichnet, dass** die Fügepartner (FP) durch Infrarot- oder Halogenstrahler erwärmt werden.

10. Verfahren nach einem der Ansprüche 1 bis 8, **dadurch gekennzeichnet, dass** die Fügepartner (FP) durch Widerstandsheizung erwärmt werden.

11. Verfahren nach einem der Ansprüche 1 bis 8, **dadurch gekennzeichnet, dass** die Fügepartner (FP) mittels Kontaktheizung erwärmt werden.

12. Verfahren nach einem der Ansprüche 1 bis 8, **dadurch gekennzeichnet, dass** die Fügepartner (FP) mittels Konvektionsheizung erwärmt werden.

13. Verfahren nach einem der Ansprüche 1 bis 8, **dadurch gekennzeichnet, dass** die Fügepartner (FP) mittels Laserstrahl erwärmt werden.

## Claims

1. Vacuum soldering procedure for void-free reflow-soldering of join partners (FP) under vacuum in a recipient (1) like electric components or the like on circuit boards or other support elements by charging the join partners (FP) to be interconnected into the recipient (1), decreasing the pressure in the recipient (1) and simultaneous heating up the join partners (FP) and ignition of a plasma, **characterized by** the fact that the ignition of the plasma in the recipient (1) occurs if the chamber pressure required for the ignition is reached or the plasma is ignited as a remote plasma in a pre-chamber (11) and then introduced into the recipient (1), injecting of water into the recipient (1) and splitting off into hydrogen ions and oxygen ions by the plasma, activating of the surfaces of the join partners (FP) and the solder by oxidation and removal of the carbon layer and subsequent bonding of the oxygen of the oxide layer to the hydrogen, terminating the reflow-soldering process and venting the recipient (1) after the expiration of a defined waiting time.

2. Procedure according to claim 1, **characterized by** the fact that the plasma ignited in the recipient (1) is a low pressure plasma within the RF range (kHz...MHz).

3. Procedure according to claim 1, **characterized by** the fact that the plasma is a low pressure plasma within the GHz range.

4. Procedure according to claim 1, **characterized by** the fact that the pressure in the recipient (1) is lowered to 10⁻³ mbar.

5. Procedure according to claim 1, **characterized by** the fact that the join partners (FP) are heated up by progressive stages.

6. Procedure according to claim 5, **characterized by** the fact that the join partners (FP) are initially heated to a temperature below the soldering temperature to activate the surfaces of the join partners and heated to the soldering temperature after a preset time.

7. Procedure according to claim 6, **characterized by** the fact that the pressure in the recipient (1) is temporary further lowered if the soldering temperature is attained.

8. Procedure according to claim 1, **characterized by** the fact that the water is pre-heated before its injection into the recipient (1).

9. Procedure according to any of the claims 1 to 8, **characterized by** the fact that the join partners (FP) are heated up by infrared or halogen radiation.

10. Procedure according to any of the claims 1 to 8, **characterized by** the fact that the join partners (FP) are heated up by resistance heating.

11. Procedure according to any of the claims 1 to 8, **characterized by** the fact that the join partners (FP) are heated up by contact heating.

12. Procedure according to any of the claims 1 to 8, **characterized by** the fact that the join partners (FP) are heated up by convection heating.

13. Procedure according to any of the claims 1 to 8, **characterized by** the fact that the join partners (FP) are heated up by a laser beam.

## Revendications

1. Procédure de brasage pour un brasage par refusion sans retassures des pièces à jointer (FP) sous vide dans un récipient (1), comme les composants électriques et d'autres choses semblables sur les cartes imprimées ou d'autres éléments porteurs par le chargement des pièces à jointer (FP) l'une à l'autre dans le récipient (1) et la diminution de la pression dans le récipient (1) ainsi que le réchauffement simultané des pièces à jointer (FP) et l'amorçage du plasma, **caractérisé en ce que** l'amorçage du plasma dans le récipient (1) est initié au moment de l'obtention d'une pression requise dans le récipient (1) ou le plasma est amorcé dans une préchambre en tant que plasma à distance puis introduit dans le récipient (1), de l'eau est injectée dans le récipient (1) et décomposée en ions d'hydrogène et d'oxygène par le plasma, la surface des pièces à jointer (FP) et de la pâte de brasure est activée par l'oxydation et l'ablation de la couche carbonique, l'oxygène de la couche oxydée est recombiné avec l'hydrogène, puis le procédé de brasage par refusion est terminé et le récipient (1) est aéré après écoulement du délai d'attente fixé.

2. Procédure selon la revendication 1, **caractérisé en ce que** le plasma amorcé dans le récipient (1) est un plasma à basse pression dans la plage des radiofréquences (kHz...MHz).

3. Procédure selon la revendication 1, **caractérisé en ce que** le est un plasma à basse pression dans la plage des fréquences GHz.

4. Procédure selon la revendication 1, **caractérisé en ce que** la pression dans le récipient (1) est diminuée à 10⁻³ mbar.

5. Procédure selon la revendication 1, **caractérisé en ce que** les pièces à jointer (FP) sont chauffées par paliers.

6. Procédure selon la revendication 5, **caractérisé en ce que** les pièces à jointer (FP) sont chauffées à une température au-dessous de la température de soudure pour activer la surface des pièces à jointer (FP) dans un premier temps et à la température de soudure dans un deuxième temps.

7. Procédure selon la revendication 6, **caractérisé en ce que** la pression dans le récipient (1) est temporellement continuée à être diminuée une fois que la température de soudure est atteint.

8. Procédure selon la revendication 1, **caractérisé en ce que** l'eau est préchauffée avant d'être injectée dans le récipient / la chambre à vide(1).

9. Procédure selon l'une des revendications 1 à 8, **caractérisé en ce que** les pièces à jointer (FP) sont chauffées par rayonnement infrarouge ou halogène.

10. Procédure selon l'une des revendications 1 à 8, **caractérisé en ce que** les pièces à jointer (FP) sont chauffées par un chauffage à résistance.

11. Procédure selon l'une des revendications 1 à 8, **caractérisé en ce que** les pièces à jointer (FP) sont chauffées par un chauffage à contact.

12. Procédure selon l'une des revendications 1 à 8, **caractérisé en ce que** les pièces à jointer (FP) sont chauffées par un chauffage à convection.

13. Procédure selon l'une des revendications 1 à 8, **caractérisé en ce que** les pièces à jointer (FP) sont chauffées par un faisceau laser.
